# EUROPÄISCHE PATENTANMELDUNG

(11) **EP 1 338 842 A2**
(43) Veröffentlichungstag der Anmeldung: **27.08.2003**
(21) Anmeldenummer: 03001488.0
(22) Anmeldetag: 23.01.2003
(51) Int. Cl.: F16M 13/00

(54) **Träger für ein Mischpult und Scharnier für einen solchen Träger**

(30) Priorität: 21.02.2002 DE 20202781 U
(71) Anmelder: Glaum, Peter, 35440 Linden (DE)
(72) Erfinder: Glaum, Peter, 35440 Linden (DE)
(74) Vertreter: Körner, Volkmar Horst

(57) **Zusammenfassung**

Bei einem Träger (1) für ein Mischpult (3) oder ein flaches Musikgerät mit einem Grundteil (2) und einer das Grundteil (2) teilweise überdeckenden Abdeckung (4), ist die Abdeckung (4) über ein Scharnier (12) mit dem Grundteil (2) verbunden, und das Scharnier (12) hat zwei parallele Lagerachsen (13, 14). Die Lagerachsen (13, 14) lagern jeweils eine Befestigungslasche (15, 16) mit einem gemeinsamen Mittelstück (17) schwenkbar gegeneinander. Eine der Befestigungslaschen (15) ist an dem Grundteil (2) und die andere Befestigungslasche (16) an der Abdekkung (4) befestigt.

## Beschreibung

Die Erfindung betrifft einen Träger für ein Mischpult oder ein flaches Musikgerät mit einem Grundteil und einer das Grundteil teilweise überdeckenden Abdekkung, wobei der von der nicht von der Abdeckung überdeckte Bereich des Grundteils im Wesentlichen zur Aufnahme des Mischpultes oder des Musikgerätes und der von der Abdeckung überdeckte Bereich im Wesentlichen zur Aufnahme von Anschlussleitungen des Mischpultes oder des Musikgerätes vorgesehen ist. Weiterhin betrifft die Erfindung ein Scharnier zur Lagerung einer Abdeckung an einem Grundteil eines Trägers.

Ein solcher Träger ist beispielsweise aus der DE 297 02 004 U1 bekannt. Hierbei sind zwei mit dem Mischpult verbundene Schwenkstützen auf einem Ständer montiert. Das Mischpult lässt sich im montierten Zustand von einer horizontalen Lage in eine vertikale Lage schwenken. Nachteilig bei dem bekannten Träger ist, dass die Anschlussleitungen des auf dem Grundteil montierten Mischpultes nicht zuverlässig geschützt sind.

Daher ist es aus der Praxis bekannt, die Abdekkung lose auf das Grundteil in den Bereich der Anschlussleitungen aufzusetzen. Hierdurch gestaltet sich jedoch die Hantierung der Abdeckung sehr unkomfortabel.

Der Erfindung liegt das Problem zugrunde, einen Träger der eingangs genannten Art so weiterzubilden, dass sich mit ihm die Anschlussleitungen des Mischpultes besonders komfortabel abdecken lassen. Weiterhin liegt der Erfindung das Problem zugrunde, ein Scharnier für einen solchen Träger zu entwickeln, welcher besonders einfach montierbar ist.

Dieses Problem wird erfindungsgemäß dadurch gelöst, dass die Abdeckung über ein Scharnier mit dem Grundteil verbunden ist, dass das Scharnier zwei parallele Lagerachsen aufweist, dass die Lagerachsen jeweils eine Befestigungslasche mit einem gemeinsamen Mittelstück schwenkbar gegeneinander lagern und dass eine der Befestigungslaschen an dem Grundteil und die andere Befestigungslasche an der Abdeckung befestigt ist.

Durch diese Gestaltung ist die Abdeckung mit dem Grundteil verbunden und lässt sich bei der Montage der Anschlussleitungen an dem Mischpult einfach zurückklappen. Nach der Verlegung der Anschlussleitungen wird die Abdeckung über die Anschlussleitungen geklappt und ist dank des Scharniers genau gegenüber dem das Mischpult aufnehmenden Bereich des Grundteils ausgerichtet. Im einfachsten Fall sind dank der Erfindung keine Zentrierelemente zur Ausrichtung der Abdeckung auf dem Grundteil erforderlich. Hierdurch lassen sich die Anschlussleitungen des Mischpultes besonders komfortabel abdecken. Die Erfindung eignet sich daher nicht nur für einen Träger eines Mischpultes, sondern auch für allgemein auf Trägern montierte Musikgeräte wie elektronische Orgeln oder Anlagen für Diskjockeys.

Die Abdeckung weist gemäß einer vorteilhaften Weiterbildung der Erfindung im heruntergeklappten Zustand besonders geringe Abmessungen auf, wenn sie eine Rückwand und eine Deckplatte hat und wenn die Rückwand gegenüber der Deckplatte über ein zweites Scharnier schwenkbar gelagert ist. Das zweite Scharnier kann eine einzige Lagerachse aufweisen. Durch diese Gestaltung können die Bauteile der Abdeckung glatt von dem Grundteil herunterhängen und stören daher nicht bei der Montage des Mischpultes und der Verlegung der Anschlussleitungen.

Das Mischpult ist gemäß einer anderen vorteilhaften Weiterbildung der Erfindung zuverlässig vor Beschädigung geschützt, wenn das Grundteil einen um den Bereich der Aufnahme für das Mischpult oder das Musikgerät und den von der Abdeckung überdeckten Bereich umlaufenden Rand hat. Der Rand wird von dem Mittelstück des die Abdeckung an dem Grundteil befestigenden Scharniers überbrückt, so dass die Bauteile der Abdeckung auch bei dieser Gestaltung glatt herunterhängen können.

Die Anschlussleitungen sind zuverlässig durch die Abdeckung geschützt und lassen sich gemäß einer anderen vorteilhaften Weiterbildung der Erfindung mit besonders geringem Aufwand verlegen, wenn die Abdeckung eine im Wesentlichen senkrecht zur Rückwand und zur Deckplatte angeordnete Seitenwand mit einer Ausnehmung zur Durchführung der Anschlussleitungen hat. Weiterhin ermöglicht diese Gestaltung eine besonders einfache Zugentlastung der Anschlüsse der Anschlussleitungen an dem Mischpult.

Von der heruntergeklappten Abdeckung abstehende Bauteile lassen sich gemäß einer anderen vorteilhaften Weiterbildung der Erfindung einfach vermeiden, wenn die Seitenwand auf dem Grundteil befestigt ist.

Das zweitgenannte Problem, nämlich die Schaffung eines besonders einfach montierbaren Scharniers, wird erfindungsgemäß dadurch gelöst, dass zwei Befestigungslaschen an einem Mittelstück schwenkbar gelagert sind und dass die Befestigungslaschen auf dieselbe Seite des Mittelstücks zuschwenkbar sind. Das Scharnier lässt sich besonders kostengünstig fertigen, wenn die Befestigungslaschen des Mittelstücks als Blechstreifen gefertigt sind.

Die Erfindung lässt zahlreiche Ausführungsformen zu. Zur weiteren Verdeutlichung ihres Grundprinzips ist eine davon in der Zeichnung dargestellt und wird nachfolgend beschrieben. Diese zeigt in
- Fig.1: schematisch eine Seitenansicht eines erfindungsgemäßen Trägers mit einem darauf montierten Mischpult,
- Fig.2: eine stark vergrößerte Darstellung eines Scharniers für den erfindungsgemäßen Träger aus Figur 1,
- Fig.3: das Scharnier aus Figur 2 in einer Draufsicht.

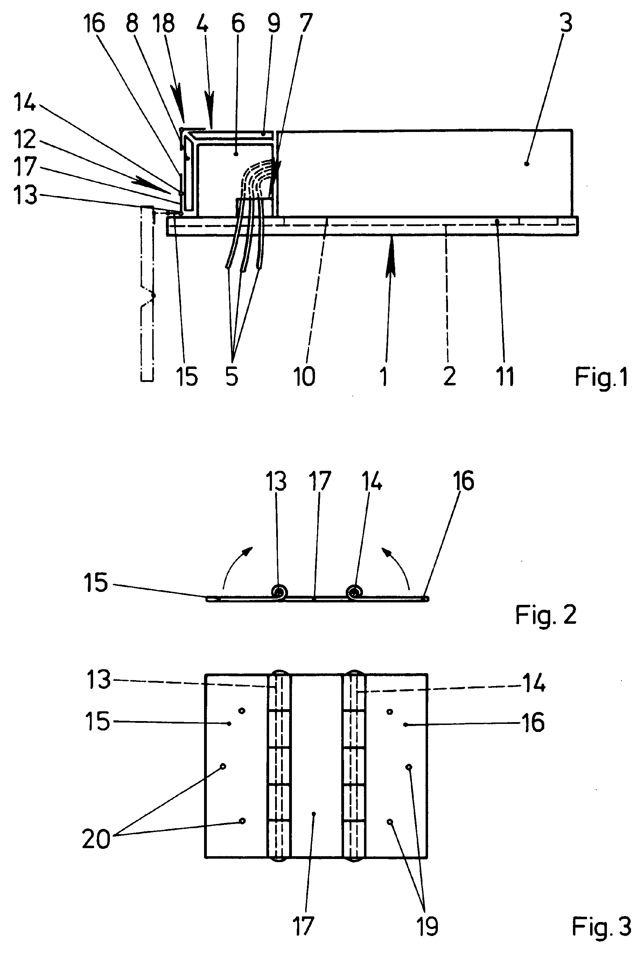

Figur 1 zeigt einen Träger 1 mit einem auf einem Grundteil 2 montierten Mischpult 3. Der Träger 1 weist eine Abdeckung 4 für Anschlussleitungen 5 des Mischpultes 3 auf. Die Abdeckung 4 hat eine Seitenwand 6 mit einer Ausnehmung 7 zur Durchführung der Anschlussleitungen 5 und eine mit einer Rückwand 8 verbundene Deckplatte 9. Weiterhin hat das Grundteil 2 Aufnahmeplatten 10 für das Mischpult 3 und einen umlaufenden Rand 11. Das Grundteil 2 kann beispielsweise als Holzplatte oder Metallgestell ausgebildet sein.

Die Seitenwand 6 ist fest auf dem Grundteil 2 montiert, während die Rückwand 8 über ein Scharnier 12 mit zwei Lagerachsen 13, 14 mit dem Grundteil 2 verbunden ist. Das Scharnier 12 weist hierfür zwei an jeweils einer der Lagerachsen angelenkte Befestigungslaschen 15, 16 auf, mit denen es mit dem Grundteil 2 und der Rückwand 8 verschraubt ist. Die Lagerachsen 13, 14 sind über ein Mittelstück 17 miteinander verbunden. Die Deckplatte 9 ist über ein weiteres Scharnier 18 mit der Rückwand 8 verbunden. Zum Anschluss der Anschlussleitungen 5 an das Mischpult 3 lässt sich die Abdeckung 4 zurückklappen. Dabei überbrückt das Mittelstück 17 des einen Scharniers 12 den Rand 11 des Grundteils 2 und ermöglicht ein Herabhängen der Rückwand 8. Das zweite Scharnier 18 ermöglicht ein Herabhängen der Deckplatte 9 von der Rückwand 8. Zur Verdeutlichung ist die Abdeckung 4 in der Zeichnung im heruntergeklappten Zustand strichpunktiert dargestellt.

Figur 2 zeigt stark vergrößert das die Abdeckung 4 mit dem Grundteil 2 verbindende Scharnier 12 in einer Seitenansicht. Figur 3 zeigt das Scharnier 12 aus Figur 2 in einer Draufsicht. Hierbei ist zu erkennen, dass die Befestigungslaschen 15, 16 und das Mittelstück 17 als Blechstreifen ausgebildet und im Bereich der Lagerachsen 13, 14 gerollt sind. Die Lagerachsen 13, 14 sind bolzenförmig gestaltet und werden von den gerollten Abschnitten der Befestigungslaschen 15, 16 und des Mittelstücks 17 umgriffen. Hierdurch lassen sich beide Befestigungslaschen 15, 16 gegenüber dem Mittelstück 17 verschwenken. Zur Verdeutlichung sind in der Zeichnung die Bewegungsmöglichkeiten der Befestigungslaschen 15, 16 mit Pfeilen gekennzeichnet. Die Befestigungslaschen 15, 16 weisen mehrere Befestigungsausnehmungen 19, 20 zur Durchführung von Schrauben oder dergleichen zur Befestigung an der in Figur 1 dargestellten Rückwand 8 und dem Grundteil 2 auf.

## Patentansprüche

1. Träger (1) für ein Mischpult (3) oder ein flaches Musikgerät mit einem Grundteil (2) und einer das Grundteil (2) teilweise überdeckenden Abdeckung (4), wobei der von der nicht von der Abdeckung (4) überdeckte Bereich des Grundteils (2) im Wesentlichen zur Aufnahme des Mischpultes (3) oder des Musikgerätes und der von der Abdeckung (4) überdeckte Bereich im Wesentlichen zur Aufnahme von Anschlussleitungen (5) des Mischpultes (3) oder des Musikgerätes vorgesehen ist, **dadurch gekennzeichnet, dass** die Abdeckung (4) über ein Scharnier (12) mit dem Grundteil (2) verbunden ist, dass das Scharnier (12) zwei parallele Lagerachsen (13, 14) aufweist, dass die Lagerachsen (13, 14) jeweils eine Befestigungslasche (15, 16) mit einem gemeinsamen Mittelstück (17) schwenkbar gegeneinander lagern und dass eine der Befestigungslaschen (15) an dem Grundteil (2) und die andere Befestigungslasche (16) an der Abdeckung (4) befestigt ist.

2. Träger nach Anspruch 1, **dadurch gekennzeichnet, dass** die Abdeckung (4) eine Rückwand (8) und eine Deckplatte (9) hat und dass die Rückwand (8) gegenüber der Deckplatte (9) über ein zweites Scharnier (18) schwenkbar gelagert ist.

3. Träger nach Anspruch 1 oder 2, **dadurch gekennzeichnet, dass** das Grundteil (2) einen um den Bereich der Aufnahme für das Mischpult (3) oder für das Musikgerät und den von der Abdeckung (4) überdeckten Bereich umlaufenden Rand (11) hat.

4. Träger nach zumindest einem der vorhergehenden Ansprüche, **dadurch gekennzeichnet, dass** die Abdeckung (4) eine im Wesentlichen senkrecht zur Rückwand (8) und zur Deckplatte (9) angeordnete Seitenwand (6) mit einer Ausnehmung (4) zur Durchführung der Anschlussleitungen (5) hat.

5. Träger nach zumindest einem der vorhergehenden Ansprüche, **dadurch gekennzeichnet, dass** die Seitenwand (6) auf dem Grundteil (2) befestigt ist.

6. Scharnier, insbesondere zur Lagerung einer Abdeckung an einem Grundteil eines Trägers nach zumindest einem der vorhergehenden Ansprüche, **dadurch gekennzeichnet, dass** zwei Befestigungslaschen (15, 16) an einem Mittelstück (17) schwenkbar gelagert sind und dass die Befestigungslaschen (15, 16) auf dieselbe Seite des Mittelstücks (17) zuschwenkbar sind.

7. Scharnier nach Anspruch 6, **dadurch gekennzeichnet, dass** die Befestigungslaschen (15, 16) des Mittelstücks (17) als Blechstreifen gefertigt sind.
